Europäisches Patentamt

European Patent Office

Office européen des brevets

(11) Publication number: **0 146 636**
**B1**

(19)

(12) # EUROPEAN PATENT SPECIFICATION

(45) Date of publication of patent specification: **11.10.89**

(51) Int. Cl.⁴: **G 11 B 5/09**

(21) Application number: **84902365.0**

(22) Date of filing: **13.06.84**

(86) International application number:
**PCT/JP84/00307**

(87) International publication number:
**WO 85/00066 03.01.85 Gazette 85/01**

(54) **SYNCHRONIZING CIRCUIT.**

(30) Priority: **14.06.83 JP 106257/83**

(43) Date of publication of application:
**03.07.85 Bulletin 85/27**

(45) Publication of the grant of the patent:
**11.10.89 Bulletin 89/41**

(84) Designated Contracting States:
**AT DE FR GB NL**

(56) References cited:
EP-A-0 074 039
DE-A-3 151 251
JP-A-5 665 320
JP-A-58 194 117

IBM TECHNICAL DISCLOSURE BULLETIN, vol.
17, no. 5, October 1974, pages 1460-1463, New
York, US; J.E. GUEST et al.: "Logical sector
interleave"

(73) Proprietor: **SONY CORPORATION**
**7-35 Kitashinagawa 6-Chome Shinagawa-ku**
**Tokyo 141 (JP)**

(72) Inventor: **ODAKA, Kentaro Sony Corporation**
**7-35, Kitashinagawa 6-chome**
**Shinagawa-ku Tokyo 141 (JP)**
Inventor: **FUKAMI, Tadashi Sony Corporation**
**7-35, Kitashinagawa 6-chome**
**Shinagawa-ku Tokyo 141 (JP)**
Inventor: **OZAKI, Shinya Sony Corporation**
**7-35, Kitashinagawa 6-chome**
**Shinagawa-ku Tokyo 141 (JP)**

(74) Representative: **Ayers, Martyn Lewis Stanley**
**et al**
**J.A. KEMP & CO. 14 South Square Gray's Inn**
**London, WC1R 5EU (GB)**

EP 0 146 636 B1

## Description

Technical field

This invention relates to a synchronizing circuit for use with a PCM demodulating apparatus.

Background art

In the prior art, an apparatus is proposed, in which a rotary head of, for example, a helical scan type is used, a recording tape is wrapped around a drum of the rotary head with a wrapping angle of 90°, PCM data of an audio signal is timebase-compressed and then recorded on the recording tape during every period in which the rotary head comes in contact with the recording tape with an angular range of 90°.

In such apparatus, since the signal is compressed in timebase upon recording and reproduced intermittently upon playback, it is very difficult to establish accurate synchronization.

On the other hand, in a special playback mode such as a playback mode with a different reproducing speed, reproduced data is also thinned out so that it becomes more difficult to establish the synchronization.

Therefore, it was considered that together with a synchronizing signal, an address signal was added to a data signal every block including a predetermined number of bits. According to this method, upon playback, the address signal is detected to enable the accurate synchronisation to be obtained.

In this case, however, the address signal requires a counter-measure such as an error correction and the like similarly to the data signal. In that case, in the prior art, an error correction code is added in common to both of the address signal and the data signal.

However, in this method, since the error correction code is added to the whole of the address and data signals, it is not possible to enhance the error correction ability by interleaving only the data signal. Alternatively, to carry out such interleaving, the address signal must be also stored and this requires a memory of a large capacity.

Further, in order to judge whether the address signal is correct or erroneous, the whole of one block must be checked and this needs a memory with a capacity of one block. Furthermore, there is a problem that even when PCM data portion is correct, if the address portion is erroneous, the whole of one block becomes erroneous and the like.

It may be noted that address signals having their own error detection signals is known from IBM Technical Disclosure Bulletin Vol. 17, No. 5, October 1974; pp 1460—1463—J Guest et al, "Logical Sector Interleave".

In view of the above, it is an object of this invention to provide a circuit of a simple construction capable of establishing accurate synchronisation.

According to the present invention, there is provided a synchronising circuit for a data signal in which a data signal is divided into signal blocks at every predetermined number of bits, and each signal block has added thereto a first synchronising signal, an address signal and an error detection signal for said address signal comprising means for detecting said synchronising signal; means for detecting the address signal and the error detection signal from the transmitted data; and means for detecting an error of said address signal by utilising the error detection signal and for generating a detection signal when the address signal is judged to be correct; characterised by an interpolation synchronising signal generating circuit for producing a further synchronising signal, the synchronisation of the further synchronising signal relative to the first synchronising signal being reset when the address signal is judged by the detecting means as being correct and an interpolation address signal generating circuit, said interpolation address signal generating circuit being driven by the further synchronising signal from said interpolation synchronising signal generating circuit, and means for selecting said address signal and said interpolation address signal, respectively, depending on whether said address signal is correct or erroneous to control writing of the data signal to a memory.

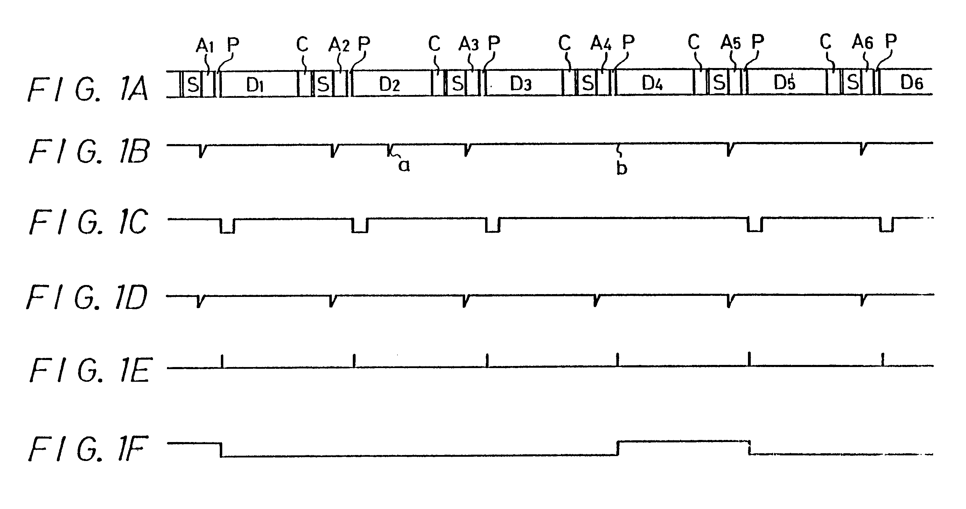

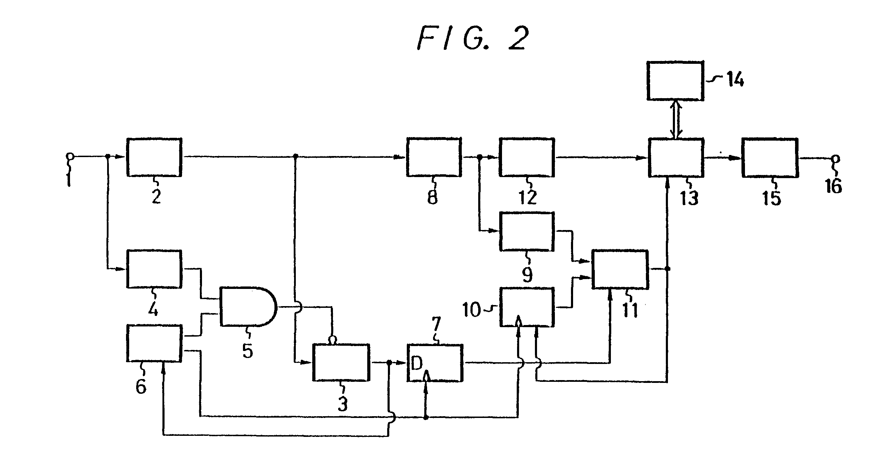

Figure 1 is a diagram useful for explaining this invention and Figure 2 is a block diagram showing an embodiment of this invention.

Figure 1A shows a signal to be transmitted, in which reference letter S designates a synchronising signal. This synchronising signal S is followed by an address signal A, error detection bits P for the address signal A, a data signal D and an error correction code C for the data signal D to be a succeeding signal. This signal is transmitted sequentially. As the synchronising signal, there is used an inhibited pattern or the like that does not exist inherently in the data signal, ie, a bit pattern which does not occur in valid data.

Figure 2 is a block diagram of a reproducing apparatus including the synchronising circuit, in which the above mentioned signal is supplied to an input terminal 1 as an RF signal that is modulated in, for example, NRZ-coding. This signal is supplied to a demodulating circuit 2 and demodulated to a code signal having levels of "1" and "0". This code signal is supplied to an error detecting circuit 3 for the address signal.

The RF signal from the input terminal 1 is supplied to a synchronising signal detecting circuit 4. In this case, since the above inhibited pattern or the like is employed, the synchronising signal S can be directly detected from the RF signal as, for example, shown in Figure 1B. This synchronising signal S is supplied through an AND circuit 5 to the reset terminal of the detecting circuit 3. This detecting circuit uses the address signal A and the error detecting bits P to judge whether the address signal is correct or erroneous and then produces a signal which becomes low level when the address signal is correct, as shown in Fig. 1C.

This signal is supplied to an interpolation synchronizing signal source 6 which then produces an interpolation synchronizing signal as shown in Fig. 1D. This signal therefrom is supplied to the AND circuit 5. Further, this interpolation synchronizing signal source 6 produces a clock signal at timing just after the detection bits P as shown in Fig. 1E.

Further, the signal from the detecting circuit 3 is supplied to a D-terminal of a D-type flip-flop circuit 7 and the clock signal from the signal source 6 is supplied to its clock terminal, thus a signal as shown in Fig. 1F being produced therefrom.

While, the code signal from the demodulating circuit 2 is supplied to a serial-to-parallel converting circuit 8 and the address signal A in the converted signal therefrom is supplied to an address detecting circuit 9. The clock signal from the signal source 6 is supplied to an interpolation address signal generating circuit 10 which then produces an interpolation address signal. The address signal thus detected and the interpolation address signal are both supplied to a change-over circuit 11, from which when the signal from the flip-flop circuit 7 is low in level, the address signal from the detecting circuit 9 is derived, while when it is high in level, the interpolation address signal from the generating circuit 10 is derived. The address signal thus derived is supplied to the interpolation address generating circuit 10.

The data signal D and the error correction code C portion of the signal from the serial-to-parallel converter 8 is supplied to a data detecting circuit 12. The data signal D and the error correction code C are supplied to a random-access memory 13 and the address signal from the above change-over circuit 11 is supplied to the memory 13, in which the writing is carried out on the basis of this address signal. The signal written in the memory 13 is corrected for error by an error correcting circuit 14, read out at a predetermined timing, converted to an analog signal by a D/A converter 15 and then output at an output terminal 16.

The playback is carried out in this way. According to this apparatus, since the address signal A and the error detection bits P are provided just after the synchronising signal S and whether the signal is correct or erroneous is detected, even if the synchronising signal is erroneously detected due to the error of the data signal D and so on as shown by, for example, *a* in Fig. 1, such synchronising signal is removed by the fact that the portion thereof corresponding to the address signal is erroneous. Further, since the interpolation synchronising signal source 6 is provided, when the synchronising signal S is not detected due to the error and the like as shown by *b* in Fig. 1, the synchronising signal is interpolated. Furthermore, since the interpolation address signal generating circuit 10 is provided, this address signal A is interpolated so that if only the synchronising signal S and the address signal A are erroneous, ie, the data signal D is correct, the data signal D can be utilised, namely, it is possible to detect the synchronising signal S very accurately.

In this case, moreover, since the error detecting bits P are provided immediately after the address signal A, it is sufficient for the memory for the error detection to be of very small capacity.

In the prior art, when the error detection of the address signal is not carried out, since data is written in a wrong address due to an erroneous address and a correct data is destroyed, it is expected that error rate grows to be twice that of the original one. However, according to this apparatus, since there are provided detection bits of *n* bits, it is possible to stop the deterioration of the error rate to such value expressed as

$$1 + \frac{1}{2^n - 1}$$

For example, if n=4, the deterioration of the error rate can be stopped not higher than 7%.

Upon playback mode with different reproducing speed, when the calculation matching with the speed is carried out by the interpolation address generating circuit 10 or the writing stop signal is formed thereby, the malfunction can be prevented upon playback mode with a different reproducing speed.

Table of reference numerals and components

| Reference numerals | Components |
| --- | --- |
| 1 | the input terminal |
| 2 | the demodulating circuit |
| 3 | the error detecting circuit of address signal |
| 4 | the detecting circuit of a synchronising signal |
| 5 | the AND circuit |
| 6 | the interpolation synchronising signal source |
| 7 | the D-type flip-flop circuit |
| 8 | the serial-to-parallel converting circuit |
| 9 | the address detecting circuit |
| 10 | the interpolation address signal generating circuit |
| 11 | the change-over circuit |
| 12 | the data detecting circuit |
| 13 | the random-access memory |
| 14 | the error correcting circuit |
| 15 | the D/A converting circuit |
| 16 | the output terminal |

## Claims

1. A synchronising circuit for a data signal in which a data signal is divided into signal blocks at every predetermined number of bits, and each signal block has added thereto a first synchronising signal, an address signal and an error detection signal for said address signal comprising means (4) for detecting said synchronising signal (S); means (3) for detecting the address signal (A) and the error detection signal (P) from the transmitted data; and means (3) for detecting an error of said address signal (A) by utilising the error detection signal (P) and for generating a detection signal when the address signal is judged to be correct; characterised by an interpolation synchronising signal generating circuit (6) for producing a further synchronising signal, the synchronisation of the further synchronising signal relative to the first synchronising signal being reset when the address signal (A) is judged by the detecting means (3) as being correct and an interpolation address signal generating circuit (10), said interpolation address signal generating circuit being driven by the further synchronising signal from said interpolation synchronising signal generating circuit (6), and means (11) for selecting said address signal and said interpolation address signal, respectively, depending on whether said address signal is correct or erroneous to control writing of the data signal to a memory (3).

2. A synchronising circuit according to claim 1, wherein said data signal is digital data that results from pulse-code-modulating an analog audio signal.

3. A synchronising circuit according to claim 2, wherein said data signal is recorded and reproduced by a rotary head of a helical scan type.

4. A synchronising circuit according to claim 3, in which said data signal is timebase-compressed and recorded and reproduced intermittently.

**Patentansprüche**

1. Synchronisierschaltung für ein Datensignal, das unterteilt ist in Signalblöcke mit jeweils einer vorgegebenen Anzahl von Bits, wobei jedem Signalblock ein erstes Synchronisiersignal, ferner ein Adressensignal sowie ein Fehlerdetektorsignal für die Fehlerüberwachung des Adressensignals hinzugefügt ist,

mit einer Detektoreinrichtung (4) zur Erfassung des Synchronisiersignals (S),

mit einer Detektoreinrichtung (3) zur Erfassung des Adressensignals (A) und des Fehlerdetektorsignals (P) aus den übertragenen Daten,

sowie mit einer Detektoreinrichtung (3) zur Ermittlung eines Fehlers in dem Adressensignal (A) unter Verwendung des Fehlerdetektorsignals (P) und zur Erzeugung eines Detektorsignals, wenn das Adressensignal als fehlerfrei beurteilt wird, gekennzeichnet durch

eine Interpolations-Synchronisiersignal-Generatorschaltung (6) zur Erzeugung eines weiteren Synchronisiersignals, wobei die Synchronisation dieses weiteren Synchronisiersignals relativ zu dem ersten Synchronisiersignal zurückgestellt wird, wenn das Adressensignal (A) von der Detektoreinrichtung (3) als fehlerfrei beurteilt wird,

eine von dem weiteren Synchronisiersignal der Interpolations-Synchronisiersignal-Generatorschaltung (6) angesteuerte Interpolations-Adressensignal-Generatorschaltung (10) zur Erzeugung eines Interpolations-Adressensignals

und Mittel (11), die in Abhängigkeit davon, ob das Adressensignal fehlerfrei ist oder fehlerhaft, zur Steuerung der Einspeicherung des Datensignals in einen Speicher (3) entweder das Adressensignal oder das Interpolations-Adressensignal auswählen.

2. Synchronisierschaltung nach Anspruch 1, bei der das Datensignal aus digitalen Daten besteht, die durch Pulscodemodulation eines analogen Tonsignals gewonnen werden.

3. Synchronisierschaltung nach Anspruch 2, bei der das Datensignal von einem rotierenden Kopf mit Schrägspurabtastung aufgezeichnet und wiedergegeben wird.

4. Synchronisierschaltung nach Anspruch 3, bei der das Datensignal in seiner Zeitbasis komprimiert ist und intermittierend aufgezeichnet und wiedergegeben wird.

**Revendications**

1. Circuit de synchronisation pour un signal de données dans lequel un signal de données est divisé en blocs de signal à chaque nombre prédéterminé de bits, et chaque bloc de signal comporte un premier signal de synchronisation, un signal d'adresse et un signal de détection d'erreurs pour le signal d'adresse qui lui sont ajoutés, comprenant un moyen (4) pour détecter le signal de synchronisation (S); un moyen (3) pour détecter le signal d'adresse (A) et le signal de détection d'erreurs (P) à partir des données transmises; et un moyen (3) pour détecter une erreur du signal d'adresse (A) en mettant en oeuvre le signal de détection d'erreurs (P) et pour engendrer un signal de détection quand le signal d'adresse est jugé comme étant correct; caractérisé par un circuit générateur de signaux de synchronisation d'interpolation (6) pour produire un autre signal de synchronisation, la synchronisation de l'autre signal de synchronisation relatif au premier signal de synchronisation étant remise à l'état initial quand le signal d'adresse (A) est jugé par le moyen de détection (3) comme étant correct et un circuit générateur de signaux d'adresse d'interpolation (10), le circuit générateur de signaux d'adresse d'interpolation étant commandé par l'autre signal de synchronisation provenant du circuit générateur de signaux de synchronisation d'interpolation (6), et un moyen (11) pour sélectionner le signal d'adresse et le signal d'adresse d'interpolation, respectivement, selon que le signal d'adresse est correct ou erroné pour commander l'écriture du signal de données dans une mémoire (3).

2. Circuit de synchronisation selon la revendication 1, dans lequel le signal de données est constitué de données numériques résultant de la modulation par impulsions codées d'un signal sonore analogique.

3. Circuit de synchronisation selon la revendication 2, dans lequel le signal de données est enregistré et reproduit par une tête tournante d'un type à balayage hélicoïdal.

4. Circuit de synchronisation selon la revendication 3, dans lequel le signal de données est condensé en fonction du temps et enregistré et reproduit de façon intermittente.

FIG. 1A

$A_1$ P    C  $A_2$ P    C  $A_3$ P    C  $A_4$ P    C  $A_5$ P    C  $A_6$ P

| S | | $D_1$ | | S | | $D_2$ | | S | | $D_3$ | | S | | $D_4$ | | S | | $D_5$ | | S | | $D_6$ |

FIG. 1B

a    b

FIG. 1C

FIG. 1D

FIG. 1E

FIG. 1F

EP 0 146 636 B1

F I G. 2